# EUROPEAN PATENT APPLICATION

(11) **EP 4 733 787 A1**
(43) Date of publication of application: **29.04.2026**
(21) Application number: 24854305.0
(22) Date of filing: 03.07.2024
(51) Int. Cl.: G01R 31/392, G01R 31/396, G01R 31/367, G01R 31/382, G01R 31/385, G06N 3/08, G06N 3/0475

(54) **BATTERY SERVICE LIFE PREDICTION DEVICE AND OPERATION METHOD THEREFOR**

(30) Priority: 11.08.2023 KR 20230105936
(71) Applicant: LG Energy Solution, Ltd., Seoul 07335 (KR)
(72) Inventor: JO, Hyuk Jun, Daejeon 34122 (KR)
(74) Representative: Plasseraud IP
(86) International application number: PCT/KR2024/009385
(87) International publication number: WO 2025/037753

(57) **Abstract**

A battery lifetime prediction apparatus according to one embodiment disclosed herein may include an information acquisition unit configured to acquire Tabular data of each of a plurality of batteries, an images of each of the plurality of batteries, and a lifetime after a first cycle of each of the plurality of batteries, and a learning unit configured to learn a battery lifetime predictive model through multi-modal learning based on the Tabular data, image, and lifetime after the first cycle of each of the plurality of batteries.

## Description

### [TECHNICAL FIELD]

### CROSS-REFERENCE TO RELATED APPLICATION

This application claims priority to and the benefit of Korean Patent Application No. 10-2023-0105936 filed in the Korean Intellectual Property Office on August 11, 2023, the entire contents of which are incorporated herein by reference.

### TECHNICAL FIELD

Embodiments disclosed herein relate to a battery lifetime prediction apparatus and a method of operating the same.

### [BACKGROUND ART]

Recently, research and development on secondary batteries has been actively conducted. Here, the secondary battery is a battery capable of charging and discharging and includes all recent lithium ion batteries such as conventional Ni/Cd batteries and Ni/MH batteries. Among the secondary batteries, the lithium-ion batteries have an advantage of having a much higher energy density than the conventional Ni/Cd batteries, the Ni/MH batteries, and the like. In addition, since the small and light-weight lithium ion batteries may be manufactured, the lithium ion batteries are used as a power source for mobile devices, and recently, the lithium ion batteries are attracting attention as a next-generation energy storage medium due to the expansion of the range of use to a power source for electric vehicles.

Defect detection in a battery activation process has low accuracy to the extent that it uses a voltage, a current, etc. generated during the process and is advanced defect detection aimed at detecting low-voltage defect of the battery. Therefore, there is a need for a learning model capable of supporting decision-making related to lifetime quality by detecting a lifetime defect in an early stage in the battery activation process.

### [DISCLOSURE]

### [TECHNICAL PROBLEM]

Embodiments disclosed herein are directed to providing a battery lifetime prediction apparatus and a method of operating the same, which may predict a lifetime of a battery in an early stage based on Tabular data of the battery and an image of the battery after an activation process.

Embodiments disclosed herein are also directed to providing a battery lifetime prediction apparatus and a method of operating the same, which may provide a lifetime predictive model based on a multi-modal deep learning model and augment insufficient learning data.

The objects of the embodiments disclosed herein are not limited to the above-described objects, and other objects that are not described will be able to be clearly understood by those skilled in the art from the following descriptions.

### [TECHNICAL SOLUTION]

A battery lifetime prediction apparatus according to one embodiment disclosed herein may include an information acquisition unit configured to acquire Tabular data of each of a plurality of batteries, an images of each of the plurality of batteries, and a lifetime after a first cycle of each of the plurality of batteries, and a learning unit configured to learn a battery lifetime predictive model through multi-modal learning based on the Tabular data, image, and lifetime after the first cycle of each of the plurality of batteries.

In one embodiment, the battery lifetime prediction apparatus may further include a learning data augmentation unit configured to augment learning data through a generative model (GAN), wherein the generative model may be learned based on the Tabular data and image of each of the plurality of batteries.

In one embodiment, the learning data augmentation unit may be configured to reduce a dimension of the augmented Tabular data through principal component analysis, and input the dimensionally reduced data into an image generative model and generate an image corresponding to each of the augmented Tabular data.

In one embodiment, the learning unit may be configured to embed the Tabular data of each of the plurality of batteries through a first network, embed the image of each of the plurality of batteries through a second network, and perform supervised-learning for the battery lifetime predictive model through a neural network to output a lifetime after the first cycle by concatenating the embedded Tabular data and the embedded image.

In one embodiment, the first network may include a Tabnet, and the second network may include a vision transformer.

In one embodiment, the Tabula data of each of the plurality of batteries may include information about each of the plurality of batteries when an activation process is finished, and the image of each of the plurality of batteries may include an X-ray image of each of the plurality of batteries after the activation process is finished.

In one embodiment, the Tabular data may include at least any one of a room temperature aging time, a high temperature aging time, a charge/discharge capacity, a charge/discharge voltage, a charge/discharge current, a change in charge/discharge temperature, a constant current charge time, a sealing time, and an open circuit voltage.

In one embodiment, the battery lifetime prediction apparatus may further include a lifetime prediction unit configured to predict a lifetime after a first cycle of a first battery based on Tabular data and an image of a first battery that differs from the plurality of batteries through the battery lifetime predictive model.

A method of operating a battery lifetime prediction apparatus according to one embodiment disclosed herein may include an operation of acquiring Tabular data of each of a plurality of batteries, an images of each of the plurality of batteries, and a lifetime after a first cycle of each of the plurality of batteries, and an operation of learning a battery lifetime predictive model through multi-modal learning based on the Tabular data, image, and lifetime after the first cycle of each of the plurality of batteries.

In one embodiment, the method may further include an operation of augmenting learning data through a generative model (GAN), wherein the generative model may be learned based on the Tabular data and image of each of the plurality of batteries.

In one embodiment, the operation of augmenting the learning data through the generative model (GAN) may include an operation of reducing a dimension of the augmented Tabular data through principal component analysis, and an operation of inputting the dimensionally reduced data into an image generative model and generating an image corresponding to each of the augmented Tabular data.

In one embodiment, the operation of learning the battery lifetime predictive model through multi-modal learning based on the Tabular data, image, and lifetime after the first cycle of each of the plurality of batteries may include an operation of embedding the Tabular data of each of the plurality of batteries through a first network, an operation of embedding the image of each of the plurality of batteries through a second network, and an operation of performing supervised-learning for the battery lifetime predictive model through a neural network to output the lifetime after the first cycle by concatenating the embedded Tabular data and the embedded image.

In one embodiment, the first network may include a Tabnet, and the second network may include a vision transformer.

In one embodiment, the Tabula data of each of the plurality of batteries may include information about each of the plurality of batteries when an activation process is finished, and the image of each of the plurality of batteries may include an X-ray image of each of the plurality of batteries after the activation process is finished.

In one embodiment, the Tabular data may include at least any one of a room temperature aging time, a high temperature aging time, a charge/discharge capacity, a charge/discharge voltage, a charge/discharge current, a change in charge/discharge temperature, a constant current charge time, a sealing time, and an open circuit voltage.

In one embodiment, The method may further include an operation of predicting a lifetime after a first cycle of a first battery based on Tabular data and an image of a first battery that differs from the plurality of batteries through the battery lifetime predictive model.

### [ADVANTAGEOUS EFFECTS]

The battery lifetime prediction apparatus and the method of operating the same according to one embodiment disclosed herein can learn the lifetime predictive model based on the Tabular data and image of the battery after the activation process.

The battery lifetime prediction apparatus and the method of operating the same according to one embodiment disclosed herein can learn the Tabular data and image of the battery based on the multi-modal deep learning model.

The battery lifetime prediction apparatus and the method of operating the same according to one embodiment disclosed herein can secure the insufficient data by augmenting data necessary for learning.

In addition, various effects that may be directly or indirectly identified through the present document can be provided.

### [DESCRIPTION OF DRAWINGS]

FIG. 1 is a view showing a functional block diagram of a battery lifetime prediction apparatus according to one embodiment disclosed herein.
FIG. 2 is a block diagram specifically showing the battery lifetime prediction apparatus according to one embodiment disclosed herein.
FIG. 3 is a view showing an example in which the battery lifetime prediction apparatus according to one embodiment disclosed herein augments data.
FIG. 4 is a view showing an example in which the battery lifetime prediction apparatus according to one embodiment disclosed herein learns a battery lifetime predictive model.
FIG. 5 is a view showing a method of operating the battery lifetime prediction apparatus according to one embodiment disclosed herein.
FIGS. 6 and 7 are views specifically showing the method of operating the battery lifetime prediction apparatus according to one embodiment disclosed herein.

### [MODE FOR INVENTION]

Hereinafter, embodiments disclosed herein will be described in detail with reference to exemplary drawings. In adding reference numerals to components in each drawing, it should be noted that the same components have the same reference numerals as much as possible even when they are illustrated in different drawings. In addition, in describing embodiments disclosed herein, the detailed description of related known configurations or functions will be omitted when it is determined that the detailed description obscures the understanding of the embodiments disclosed herein.

The terms, such as first, second, A, B, (a), and (b) may be used to describe components of the embodiments disclosed in this document. These terms are only for the purpose of distinguishing one component from another, and the nature, sequence, order, or the like of the corresponding component is not limited by the terms. In addition, unless otherwise defined, all terms (including technical and scientific terms) used herein have the same meanings as those commonly understood by those skilled in the art to which embodiments disclosed herein pertains. The terms defined in a generally used dictionary should be construed as meanings that match with the meanings of the terms from the context of the related technology and are not construed as an ideal or excessively formal meaning unless clearly defined in this application.

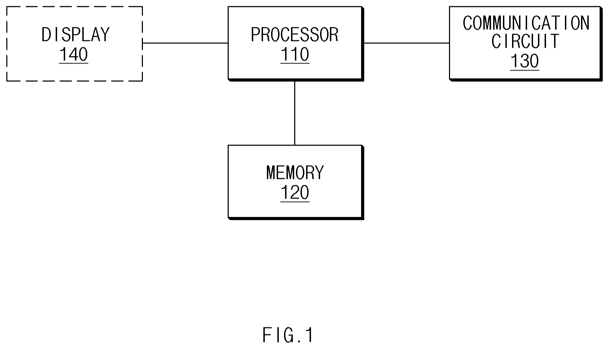

FIG. 1 is a view showing a functional block diagram of a battery lifetime prediction apparatus according to one embodiment disclosed herein.

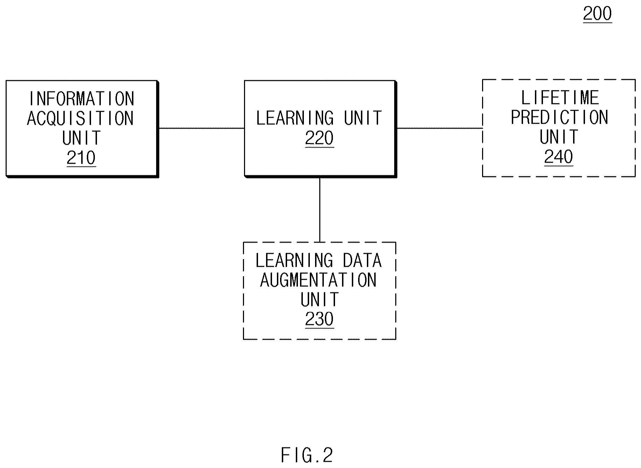

Referring to FIG. 1, a battery lifetime prediction apparatus 200 (see FIG. 2) according to one embodiment disclosed herein may include a processor 110, a memory 120, and a communication circuit 130. According to an embodiment, the battery lifetime prediction apparatus 200 may further include a display 140.

According to an embodiment, an operation of the battery lifetime prediction apparatus 200 may be performed by a battery management system (BMS) in a vehicle and performed in various devices such as a server, a cloud, a charger, or a charging/discharging device.

The processor 110 may control the overall operation of the battery lifetime prediction apparatus 200. In various embodiments, the processor 110 may include one processor core (single core) or include a plurality of processor cores. For example, the processor 110 may include a multi-core, such as a dual-core, a quad-core, or a hexa-core. According to embodiments, the processor 110 may further include a cache memory located internally or externally. According to embodiments, the processor 110 may be configured as one or more processors. For example, the processor 110 may include at least one of an application processor, a communication processor, or a graphical processing unit (GPU).

All or some of the processors 110 may be electrically or operatively coupled with or connected to other components (e.g., the memory 120, the communication circuit 130, or the display 140) in the battery lifetime prediction apparatus 200. The processor 110 may receive commands of other components of the battery lifetime prediction apparatus 200, interpret the received commands, and perform calculations or process data according to the interpreted commands. The processor 110 may interpret and process messages, data, commands, or signals received from the memory 120, the communication circuit 130, or the display 140. The processor 110 may generate new messages, data, commands, or signals based on the received messages, data, commands, or signals. The processor 110 may provide the processed or generated messages, data, commands, or signals to the memory 120, the communication circuit 130, or the display 140.

The processor 110 may process data or signals generated or produced by a program. For example, the processor 110 may request commands, data, or signals to the memory 120 to execute or control the program. The processor 110 may record (or store) or update commands, data, or signals in the memory 120 to execute or control the program.

The memory 120 may store commands, control command codes, control data, or user data for controlling the battery lifetime prediction apparatus 200. For example, the memory 120 may include at least one of an application program, an operating system (OS), middleware, or a device driver.

The memory 120 may include one or more of a volatile memory and a non-volatile memory. The volatile memory may include a dynamic random access memory (DRAM), a static RAM (SRAM), a synchronous DRAM (SDRAM), a phase-change RAM (PRAM), a magnetic RAM (MRAM), a resistive RAM (RRAM), a ferroelectric RAM (FeRAM), etc. The non-volatile memory may include a read only memory (ROM), a programmable ROM (PROM), an electrically programmable ROM (EPROM), an electrically erasable programmable ROM (EEPROM), a flash memory, etc.

The memory 120 may further include a non-volatile medium such as a hard disk drive (HDD), a solid state disk (SSD), an embedded multimedia card (eMMC), or a universal flash storage (UFS).

The communication circuit 130 may support the establishment of wired or wireless communication connection between the battery lifetime prediction apparatus 200 and an external electronic device (e.g., a battery information collection device, a battery information processing device, a server, or a cloud server) and communication execution for the established connection. According to one embodiment, the communication circuit 130 may include a wireless communication circuit (e.g., a cellular communication circuit, a short range wireless communication circuit, or a global navigation satellite system (GNSS) communication circuit) or a wired communication circuit (e.g., a local area network (LAN) communication circuit or a power line communication circuit) and communicate with the external electronic device through a short range communication network, such as Bluetooth, WiFi direct, or infrared data association (IrDA), or a long distance communication network, such as a cellular network, an Internet, a computer network, using the corresponding communication circuit among the above communication circuits. Various types of the communication circuits 130 may be implemented as one chip or may each be implemented as a separate chip. According to an embodiment, since the communication circuit 130 is not an essential component of the battery lifetime prediction apparatus 200, the battery lifetime prediction apparatus 200 excluding the communication circuit 130 may be implemented.

The processor 140 may output contents, data, or signals. In various embodiments, the display 140 may display image data processed by the processor 110. According to embodiments, the display 140 may be configured as an integrated touch screen by being coupled with a plurality of touch sensors (not shown) capable of receiving a touch input, etc. When the display 140 is configured as the touch screen, the plurality of touch sensors may be disposed above the display 140 or under the display 140.

Hereinafter, the battery lifetime prediction apparatus 200 will be described in detail with reference to FIGS. 2 to 4.

FIG. 2 is a block diagram specifically showing the battery lifetime prediction apparatus according to one embodiment disclosed herein.

Referring to FIG. 2, the battery lifetime prediction apparatus 200 according to one embodiment disclosed herein may include an information acquisition unit 210 and a learning unit 220. According to an embodiment, the battery lifetime prediction apparatus 200 may further include a learning data augmentation unit 230. According to an embodiment, the battery lifetime prediction apparatus 200 may further include a lifetime prediction unit 240. According to an embodiment, the battery lifetime prediction apparatus 200 may further include the learning data augmentation unit 230 and the lifetime prediction unit 240.

According to an embodiment, each operation of the information acquisition unit 210, the learning unit 220, the learning data augmentation unit 230, and the lifetime prediction unit 240 may be performed through the processor 110 of FIG. 1.

The information acquisition unit 210 may acquire Tabular data of each of the plurality of batteries, an image of each of the plurality of batteries, and a lifetime after a first cycle of each of the plurality of batteries.

According to an embodiment, the Tabula data of each of the plurality of batteries may include information about each of the plurality of batteries when the activation process is finished. For example, the Tabular data of each of a plurality of batteries may include at least any one of a room temperature aging time, a high temperature aging time, a charge/discharge capacity, a charge/discharge voltage, a charge/discharge current, a change in charge/discharge temperature, a constant current charge time, a sealing time, and an open circuit voltage.

According to an embodiment, an image of each of the plurality of batteries may include an X-ray image of each of the plurality of batteries after the activation process is finished. However, the present document is not limited thereto, and the image of each of the plurality of batteries may include at least any one of images related to each of the plurality of batteries.

The learning unit 220 may learn a battery lifetime predictive model through multi-modal learning based on the Tabular data, image, and lifetime after the first cycle of each of the plurality of batteries. For example, the multi-modal learning may refer to a model that uses two types of pieces of data.

According to an embodiment, the learning unit 220 may preserve information about interaction between data through the multi-modal learning based on the Tabula data and image of each of the plurality of batteries, thereby learning the battery lifetime predictive model with improved prediction performance.

The learning data augmentation unit 230 may augment learning data through a generative model (generative adversarial network (GAN)). For example, the generative model may be learned based on the Tabula data and image of each of the plurality of batteries.

According to an embodiment, the learning data augmentation unit 230 may reduce the dimension of the augmented Tabula data through principal component analysis, input the dimensionally reduced data into an image generative model, and generate an image corresponding to each augmented Tabula data. For example, when generating the image corresponding to each augmented Tabula data, the learning data augmentation unit 230 may increase the randomness of the image by additionally inputting a latent vector.

The generative model (GAN) is a generative model in which two architectures acting as a generator and a discriminator interact, in which the generator may serve to deceive the discriminator by generating data, and the discriminator may serve to reveal the false of the image generated by the generator, thereby performing learning. According to an embodiment, the GAN may include a Deep Convolutional GAN (DCGAN), a Conditional GAN, an InfoGAN, a Wasserstein GAN (DCGAN), a WGAN-GP, an LSGAN, an Attention GAN, a cycle GAN, a Progressive GAN (PGGAN), a Style GAN, a BiGAN, a BEGAN, a TGAN, a CTGAN, etc. However, the present document is not limited thereto, and the generative model (GAN) may include various well-known GAN models.

According to an embodiment, the learning data augmentation unit 230 may augment the Tabula data of each of the plurality of batteries through the TGAN or CTGAN.

According to an embodiment, the learning data augmentation unit 230 may generate an image corresponding to each Tabula data augmented through a CGAN. For example, when generating the images, the learning data augmentation unit 230 may input the augmented Tabula data together with the latent vector and generate images according to the characteristics of the Tabula data.

According to an embodiment, the learning data augmentation unit 230 may learn a Tabula data augmentation model based on the Tabula data of each of the plurality of batteries. In addition, the learning data augmentation unit 230 may learn an image augmentation model based on the Tabula data and image of each of the plurality of batteries, and in this case, the Tabula data of each of the plurality of batteries may be the Tabula data with the dimension reduced through principal component analysis.

The learning unit 220 may embed the Tabula data of each of the plurality of batteries through a first network and embed the image of each of the plurality of batteries through a second network. In this case, the learning unit 220 may perform supervised-learning for a battery lifetime predictive model through a neural network to output the lifetime after the first cycle by concatenating the embedded Tabula data and the embedded images. For example, supervised learning may mean that the learning unit 220 learns the battery lifetime predictive model to output the lifetime after the first cycle by regarding the lifetime after the first cycle as the correct answer. According to an embodiment, the first network may include a Tabnet, and the second network may include a vision transformer (ViT).

According to an embodiment, the learning unit 220 may perform the supervised-learning for the battery lifetime predictive model by concatenating the Tabula data of each of the plurality of batteries and the augmented Tabula data and using, as Tabula data, and inputting the same and concatenating the image of each of the plurality of batteries and the augmented image and using, as the image, and inputting the same.

According to an embodiment, the battery lifetime predictive model may include a plurality of neural network layers. The plurality of neural network layers may each be a linear layer or a non-linear layer. For example, the linear layer may include a convolution layer, a fully connected layer, and a deconvolution layer, and the non-linear layer may include a sampling layer, a pooling layer, and an activation layer, and the present document is not limited to the above-described layers.

According to an embodiment, the learning unit 220 may learn the battery lifetime predictive model through a deep learning network. For example, the deep learning network may include various types of networks such as a Convolutional Neural Network (CNN), a Region with Convolutional Neural Network (R-CNN), a Region Proposal Network (RPN), a Recurrent Neural Network (RNN), a Stacking-based deep Neural Network (S-DNN), a State-Space Dynamic Neural Network (S-SDNN), a Deconvolution Network, a Deep Belief Network (DBN), a Restricted Boltzman Machine (RBM), a Fully Convolutional Network (FCN), a Long Short-Term Memory ( (LSTM) Network, a Feature Pyramid Network (FPN), and a Spatial PyramidPooling (SPP) and is not limited to the above-described networks. For example, the deep learning network may be based on the CNN.

According to an embodiment, the deep learning network may be a network based on an end to end learning method. The end-to-end learning may be learning in which human actions are not involved between an input and output of the network. The end-to-end learning has an advantage that once learning begins, there is no need for human intervention, such as re-executing a specific process, in the middle of learning.

According to an embodiment, the battery lifetime prediction apparatus 200 according to one embodiment disclosed herein may further include the lifetime prediction unit 240. For example, the lifetime prediction unit 240 may predict a lifetime after a first cycle of a first battery based on Tabular data and images of the first battery that differs from the plurality of batteries through the battery lifetime predictive model. For example, the lifetime prediction unit 240 may input Tabula data and images after the activation process of the first battery into the battery lifetime predictive model and predict the lifetime of the first battery after the first cycle as an output.

The battery lifetime prediction apparatus 200 according to one embodiment disclosed herein can learn the lifetime predictive model based on the Tabular data and image of the battery after the activation process.

The battery lifetime prediction apparatus 200 according to one embodiment disclosed herein can learn the Tabular data and images of the battery based on the multi-modal deep learning model.

The battery lifetime prediction apparatus 200 according to one embodiment disclosed herein can secure the insufficient data by augmenting data necessary for learning.

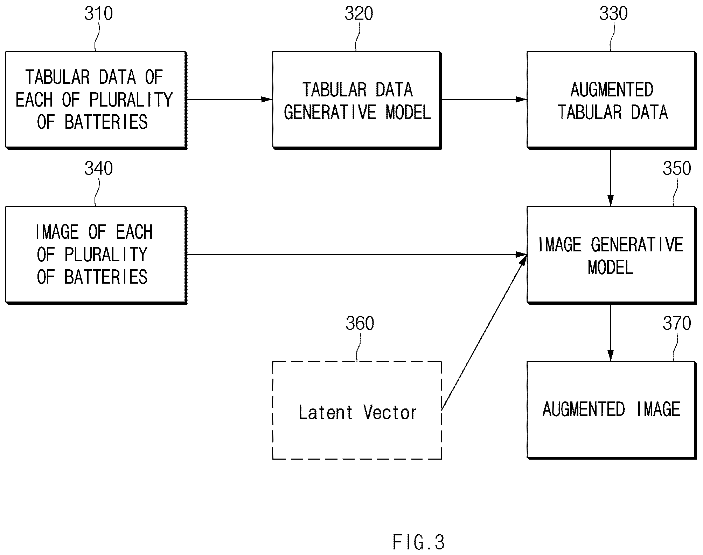

FIG. 3 is a view showing an example in which the battery lifetime prediction apparatus according to one embodiment disclosed herein augments data.

Referring to FIG. 3, the information acquisition unit 210 of the battery lifetime prediction apparatus 200 according to one embodiment disclosed herein may acquire Tabula data 310 of each of the plurality of batteries and an image 340 of each of the plurality of batteries.

The learning data augmentation unit 230 may input the Tabula data 310 of each of the plurality of batteries into a Tabula data generative model 320 and output augmented tabula data 330. According to an embodiment, the Tabula data generative model 320 may be learned based on the Tabula data 310 of each of the plurality of batteries.

The learning data augmentation unit 230 may input the image 340 of each of the plurality of batteries, the augmented Tabula data 330, and a latent vector 360 into the image generative model 350 and output an augmented image 370. For example, the image generative model 350 may be learned based on the Tabular data 310 of each of the plurality of batteries and the image 340 of each of the plurality of batteries. According to an embodiment, the latent vector 360 may be used when learning the image generative model 350 and may not be used when outputting the augmented image.

According to an embodiment, the augmented Tabula data 330 may correspond to the augmented image 370. In addition, the Tabular data 310 of each of the plurality of batteries may correspond to the image 340 of each of the plurality of batteries.

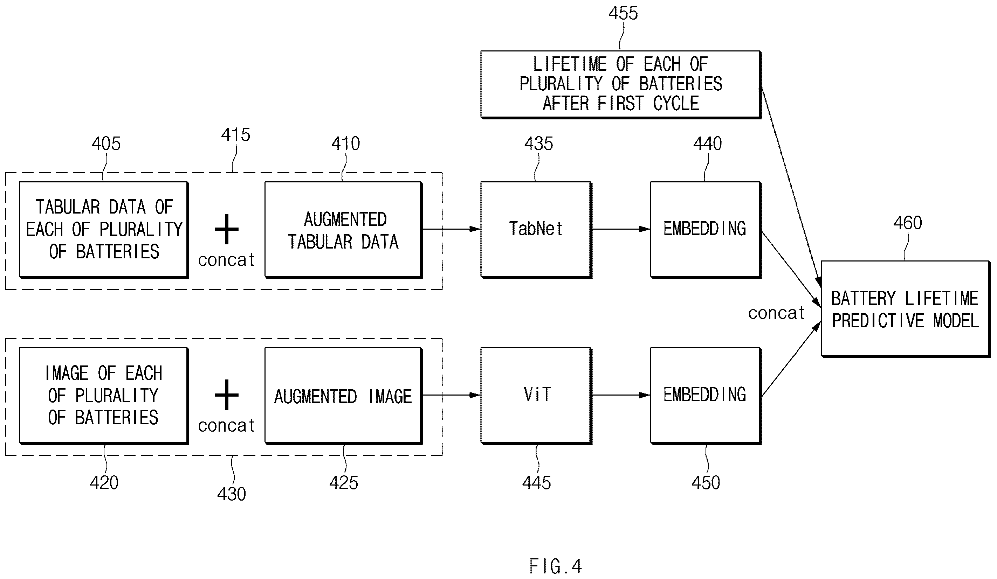

FIG. 4 is a view showing an example in which the battery lifetime prediction apparatus according to one embodiment disclosed herein learns a battery lifetime predictive model.

The learning data augmentation unit 230 may generate Tabula data 415 for model learning by concatenating Tabula data 405 of each of the plurality of batteries and augmented Tabula data 410. According to an embodiment, the Tabula data 405 of each of the plurality of batteries may be substantially the same as the Tabula data 310 of each of the plurality of batteries of FIG. 3, and the augmented Tabula data 410 may be substantially the same as the augmented Tabula data 330 of FIG. 3.

The learning data augmentation unit 230 may generate an image 430 for model learning by concatenating an image 420 of each of the plurality of batteries and an augmented image 425. According to an embodiment, the image 420 of each of the plurality of batteries may be substantially the same as the image 340 of each of the plurality of batteries of FIG. 3, and the augmented image 425 may be substantially the same as the augmented image 370 of FIG. 3.

The learning unit 220 may embed 440 the Tabula data 415 for model learning through a Tabnet 435. In addition, the learning unit 220 may embed 450 the image 430 for model learning through a vision transformer (ViT) 445.

The learning unit 220 may learn a battery lifetime predictive model 460 by concatenating the embedded Tabula data and the embedded image and inputting the same into the battery lifetime predictive model 460. For example, the learning unit 220 may learn the battery lifetime predictive model 460 to output a lifetime after the first cycle of each of the plurality of batteries 455.

According to an embodiment, the lifetime after the first cycle of each of the plurality of batteries 455 may be provided corresponding to the Tabula data 405 of each of the plurality of batteries and the image 420 of each of the plurality of batteries. In addition, the lifetime after the first cycle of each of the plurality of batteries 455 may be generated corresponding to the augmented Tabula data 410 and the augmented image 425.

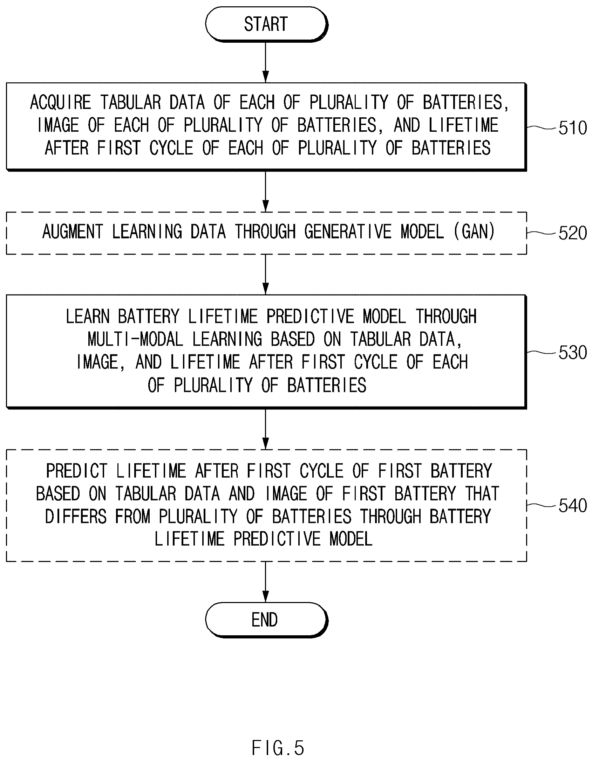

FIG. 5 is a view showing a method of operating the battery lifetime prediction apparatus according to one embodiment disclosed herein. Operations shown in FIG. 5 may be performed through the battery lifetime prediction apparatus 200 of FIG. 2.

Referring to FIG. 5, in operation 510, the information acquisition unit 210 may acquire the Tabular data of each of the plurality of batteries, the image of each of the plurality of batteries, and the lifetime after the first cycle of each of the plurality of batteries.

According to an embodiment, the Tabula data of each of the plurality of batteries may include information about each of the plurality of batteries when the activation process is finished. For example, the Tabular data of each of a plurality of batteries may include at least any one of a room temperature aging time, a high temperature aging time, a charge/discharge capacity, a charge/discharge voltage, a charge/discharge current, a change in charge/discharge temperature, a constant current charge time, a sealing time, and an open circuit voltage.

According to an embodiment, an image of each of the plurality of batteries may include an X-ray image of each of the plurality of batteries after the activation process is finished. However, the present document is not limited thereto, and the image of each of the plurality of batteries may include at least any one of images related to each of the plurality of batteries.

In operation 520, the learning data augmentation unit 230 may augment learning data through the generative model (GAN). For example, the generative model may be learned based on the Tabula data and image of each of the plurality of batteries.

According to an embodiment, the learning data augmentation unit 230 may reduce the dimension of the augmented Tabula data through principal component analysis, input the dimensionally reduced data into an image generative model, and generate an image corresponding to each augmented Tabula data. For example, when generating the image corresponding to each augmented Tabula data, the learning data augmentation unit 230 may increase the randomness of the image by additionally inputting a latent vector. According to an embodiment, operation 520 may be omitted.

According to an embodiment, the learning data augmentation unit 230 may augment the Tabula data of each of the plurality of batteries through the TGAN or CTGAN.

According to an embodiment, the learning data augmentation unit 230 may generate an image corresponding to each Tabula data augmented through the CGAN. For example, when generating the images, the learning data augmentation unit 230 may input the augmented Tabula data together with the latent vector and generate images according to the characteristics of the Tabula data.

In operation 530, the learning unit 220 may learn the battery lifetime predictive model through multi-modal learning based on the Tabular data, image, and lifetime after the first cycle of each of the plurality of batteries. For example, the multi-modal learning may refer to a model that uses two types of pieces of data.

According to an embodiment, the learning unit 220 may preserve information about interaction between data through the multi-modal learning based on the Tabula data and image of each of the plurality of batteries, thereby learning the battery lifetime predictive model with improved prediction performance.

According to an embodiment, the learning unit 220 may perform the supervised-learning for the battery lifetime predictive model by concatenating the Tabula data of each of the plurality of batteries and the augmented Tabula data and using, as Tabula data, and inputting the same and concatenating the image of each of the plurality of batteries and the augmented image and using, as the image, and inputting the same.

In operation 540, the lifetime prediction unit 240 may predict a lifetime after the first cycle of the first battery based on the Tabular data and images of the first battery that differs from the plurality of batteries through the battery lifetime predictive model.

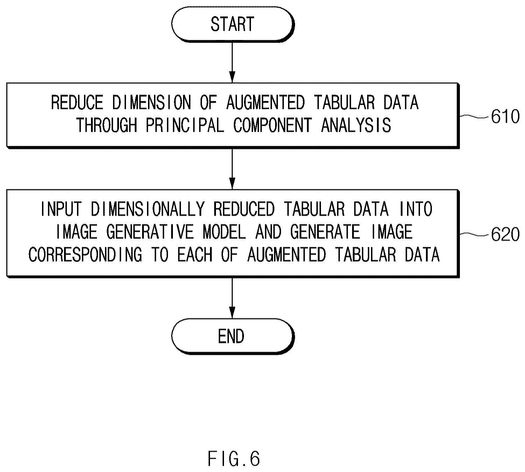

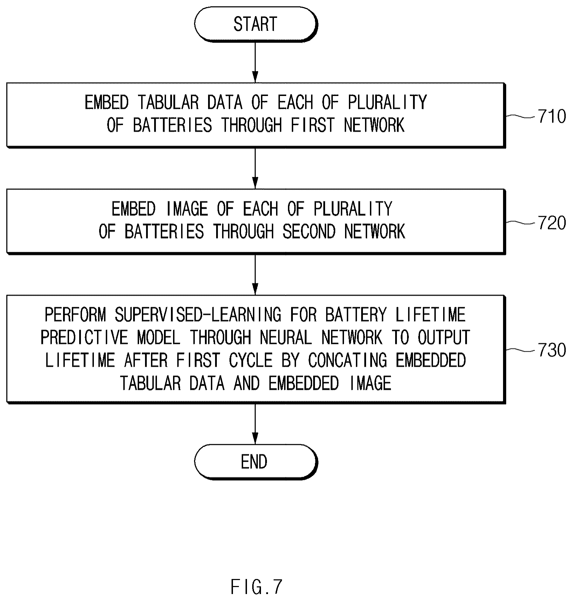

FIGS. 6 and 7 are views specifically showing the method of operating the battery lifetime prediction apparatus according to one embodiment disclosed herein. Operations shown in FIGS. 6 and 7 may be performed through the battery lifetime prediction apparatus 200 of FIG. 2.

Referring to FIG. 6, in operation 610, the learning data augmentation unit 230 may reduce the dimension of the augmented Tabula data through principal component analysis.

In operation 620, the learning data augmentation unit 230 may input the dimensionally reduced data into the image generative model and generate the image corresponding to each augmented Tabula data.

According to an embodiment, operations 610 and 620 may be performed by being included in operation 520 of FIG. 5.

Referring to FIG. 7, in operation 710, the learning unit 220 may embed the Tabula data of each of the plurality of batteries through the first network.

In operation 720, the learning unit 220 may embed the image of each of the plurality of batteries through the second network.

In operation 730, the learning unit 220 may perform supervised-learning for the battery lifetime predictive model through the neural network to output the lifetime after the first cycle by concatenating the embedded Tabula data and the embedded image. For example, supervised learning may mean that the learning unit 220 learns the battery lifetime predictive model to output the lifetime after the first cycle by regarding the lifetime after the first cycle as the correct answer. According to an embodiment, the first network may include a Tabnet, and the second network may include the vision transformer (ViT).

According to an embodiment, operations 710 and 730 may be performed by being included in operation 530 of FIG. 5.

The above description is merely the exemplary description of the technical spirit disclosed herein, and those skilled in the art to which embodiments disclosed herein pertain will be able to variously modify and change the present document without departing from the essential characteristics of the embodiments disclosed herein.

Therefore, the embodiments disclosed herein are not intended to limit the technical spirit disclosed herein, but for describing it, and the scope of the technical spirit disclosed herein is not limited by these embodiments. The scope of the technical spirit disclosed herein should be construed by the appended claims, and all technical spirits within the equivalent range should be construed as being included in the scope of the present document.

### [DESCRIPTION OF REFERENCE NUMERALS]

110: processor
120: memory
130: communication circuit
140: display
200: battery lifetime prediction apparatus
210: information acquisition unit
220: learning unit
230: learning data augmentation unit
240: lifetime prediction unit

## Claims

1. A battery lifetime prediction apparatus comprising:
an information acquisition unit configured to acquire Tabular data of each of a plurality of batteries, an images of each of the plurality of batteries, and a lifetime after a first cycle of each of the plurality of batteries; and
a learning unit configured to learn a battery lifetime predictive model through multi-modal learning based on the Tabular data, image, and lifetime after the first cycle of each of the plurality of batteries.

2. The battery lifetime prediction apparatus of claim 1, further comprising a learning data augmentation unit configured to augment learning data through a generative model (GAN),
wherein the generative model is learned based on the Tabular data and image of each of the plurality of batteries.

3. The battery lifetime prediction apparatus of claim 2, wherein the learning data augmentation unit is configured to:
reduce a dimension of the augmented Tabular data through principal component analysis; and
input the dimensionally reduced data into an image generative model and generate an image corresponding to each of the augmented Tabular data.

4. The battery lifetime prediction apparatus of claim 1, wherein the learning unit is configured to:
embed the Tabular data of each of the plurality of batteries through a first network;
embed the image of each of the plurality of batteries through a second network; and
perform supervised-learning for the battery lifetime predictive model through a neural network to output a lifetime after the first cycle by concatenating the embedded Tabular data and the embedded image.

5. The battery lifetime prediction apparatus of claim 4, wherein the first network includes a Tabnet, and the second network includes a vision transformer.

6. The battery lifetime prediction apparatus of claim 1, wherein the Tabula data of each of the plurality of batteries includes information about each of the plurality of batteries when an activation process is finished, and
the image of each of the plurality of batteries includes an X-ray image of each of the plurality of batteries after the activation process is finished.

7. The battery lifetime prediction apparatus of claim 1, wherein the Tabular data includes at least any one of a room temperature aging time, a high temperature aging time, a charge/discharge capacity, a charge/discharge voltage, a charge/discharge current, a change in charge/discharge temperature, a constant current charge time, a sealing time, and an open circuit voltage.

8. The battery lifetime prediction apparatus of claim 1, further comprising a lifetime prediction unit configured to predict a lifetime after a first cycle of a first battery based on Tabular data and an image of a first battery that differs from the plurality of batteries through the battery lifetime predictive model.

9. A method of operating a battery lifetime prediction apparatus, comprising:
an operation of acquiring Tabular data of each of a plurality of batteries, an images of each of the plurality of batteries, and a lifetime after a first cycle of each of the plurality of batteries; and
an operation of learning a battery lifetime predictive model through multi-modal learning based on the Tabular data, image, and lifetime after the first cycle of each of the plurality of batteries.

10. The method of claim 9, further comprising an operation of augmenting learning data through a generative model (GAN),
wherein the generative model is learned based on the Tabular data and image of each of the plurality of batteries.

11. The method of claim 10, wherein the operation of augmenting the learning data through the generative model (GAN) includes:
an operation of reducing a dimension of the augmented Tabular data through principal component analysis; and
an operation of inputting the dimensionally reduced data into an image generative model and generating an image corresponding to each of the augmented Tabular data.

12. The method of claim 9, wherein the operation of learning the battery lifetime predictive model through multi-modal learning based on the Tabular data, image, and lifetime after the first cycle of each of the plurality of batteries includes:
an operation of embedding the Tabular data of each of the plurality of batteries through a first network;
an operation of embedding the image of each of the plurality of batteries through a second network; and
an operation of performing supervised-learning for the battery lifetime predictive model through a neural network to output the lifetime after the first cycle by concatenating the embedded Tabular data and the embedded image.

13. The method of claim 12, wherein the first network includes a Tabnet, and the second network includes a vision transformer.

14. The method of claim 9, wherein the Tabula data of each of the plurality of batteries includes information about each of the plurality of batteries when an activation process is finished, and
the image of each of the plurality of batteries includes an X-ray image of each of the plurality of batteries after the activation process is finished.

15. The method of claim 9, wherein the Tabular data includes at least any one of a room temperature aging time, a high temperature aging time, a charge/discharge capacity, a charge/discharge voltage, a charge/discharge current, a change in charge/discharge temperature, a constant current charge time, a sealing time, and an open circuit voltage.

16. The method of claim 9, further comprising an operation of predicting a lifetime after a first cycle of a first battery based on Tabular data and an image of a first battery that differs from the plurality of batteries through the battery lifetime predictive model.
